# EUROPEAN PATENT APPLICATION

(11) **EP 3 745 469 A1**
(43) Date of publication of application: **02.12.2020**
(21) Application number: 19177245.8
(22) Date of filing: 29.05.2019
(51) Int. Cl.: H01L 31/054, H01L 25/04, H01L 31/042, H02S 40/22, F24S 23/30

(54) **OPTOMECHANICAL SYSTEM WITH HYBRID ARCHITECTURE AND CORRESPONDING METHOD FOR CONVERTING LIGHT ENERGY**

(71) Applicant: Insolight SA, 1007 Lausanne (CH)
(72) Inventor: Gerlich, Florian, 1007 Lausanne (CH); Coulot, Laurent, 1003 Lausanne (CH); Ackermann, Mathieu, 1006 Lausanne (CH); Bory, Noé, 1003 Lausanne (CH); Aguilar Jiménez, Álvaro Fernando, 1003 Lausanne (CH); Anglade, Laetitia, 1030 Bussigny (CH); Nardin, Gaël, 1024 Ecublens (CH)
(74) Representative: BOVARD AG

(57) **Abstract**

The present invention relates to an optomechanical system (1) for converting light energy, comprising
▪ an optical arrangement (40) comprising one or more optical layers (41, 42), wherein at least one of the optical layers (41,42) comprises a plurality of primary optical elements (47) to concentrate incident light (80) into transmitted light (90);
▪ a light energy conversion layer (50);
▪ a shifting mechanism (60) for moving at least one of the optical layers (41, 42) of the optical arrangement (40) relative to the light energy conversion layer (50) or vice versa; and
▪ a frame element (10) to which either the optical arrangement (40) or the light energy conversion layer (50) is attached,
wherein the light energy conversion layer (50) comprises a plurality of primary light energy conversion elements (51) and a plurality of secondary light energy conversion elements (52) capable of converting the energy of the transmitted light (90) into an output energy, wherein the primary light energy conversion elements (51) and the secondary light energy conversion elements (52) differ by type, and/or surface area, and/or light conversion efficiency, and/or light conversion spectrum, and wherein the output energy types of the primary light energy conversion elements (51) and of the secondary light energy conversion elements (52) can be different, and
wherein the shifting mechanism (60) is arranged to move at least one of the layers of the optical arrangement (40) or the light energy conversion layer (50) translationally relative to the frame element (10), through one or more translation element (65, 65') in such a way that the total output power of the primary light energy conversion elements (51) and of the secondary light energy conversion elements (52) can be adjusted.

Furthermore, the present invention also relates to a corresponding method for converting light energy with the aforementioned optomechanical system.

## Description

### Technical field of the invention

The present invention relates to the technical field of optical systems, more specifically to the technical field of optomechanical systems. In particular, the present invention relates to an optomechanical system for converting light energy in another type of energy and the corresponding method. More precisely, the present invention relates to an optomechanical system with hybrid architecture comprising at least two different types of light energy conversion elements, in particular two different types of photovoltaic cells. Such optomechanical systems can in particular be used in an advantageous way in the construction of solar panels aiming for maximizing the production of solar electricity.

### Background of the invention

A photovoltaic cell (PV cell) is a specialized semiconductor diode that converts visible light into direct current (DC). Some PV cells can also convert infrared (IR) or ultraviolet (UV) radiation into DC electricity. Photovoltaic cells are an integral part of solar-electric energy systems, such as solar panels, which are becoming increasingly important as alternative sources of utility power.

Increasing the conversion efficiency from solar energy to electricity is desirable to lower the cost of solar electricity and make it competitive with other energy sources such as fuel. However, the efficiency of standard silicon PV cells is limited to about 20 to 25%. Alternative high efficiency photovoltaic technologies based on multi-junction PV cells are much more efficient, they achieve more than 40% efficiency, but they are too expensive to be used in large area solar panel and thus acts as a direct substitution of the standard PV cells.

One solution which was proposed for making the use of high efficiency PV cells affordable is the so-called Concentrated Photo Voltaic (or CPV) approach. The CPV systems make use of a concentration of the incident sunlight on a high efficiency PV cell of smaller surface area, reducing thereby the overall costs of material. Thanks to this technique, it becomes possible to use the best existing PV cell technologies. The concentration of the sunlight makes it possible to reduce the overall surface area covered by the PV cells, without reducing the quantity of the generated electrical power. The solar concentrators make use of an optical arrangement comprising optical components, such as lenses or mirrors for the concentration of the incident sunlight on the photovoltaic cells. Consequently, CPV systems make it possible to generate electricity at a smaller cost of production than with conventional PV cells made of silicon.

The main drawback of using an optical arrangement to concentrate light on very high efficiency PV cells is the physical limit of "étendue": the higher the concentration factor, the lower the angular acceptance of the optical arrangement. Since a significant concentration factor, typically of several 100 times, is required to decrease the size of the high efficiency PV cells and make them economically viable, the angular acceptance is typically limited to few degrees or even less than one degree in most cases. For this reason, known CPV systems can only concentrate efficiently sunlight on the high-efficiency PV cells when the incident light is normal (or perpendicular) to the solar panel, precisely normal to the optical arrangement.

For this reason, CPV systems are normally mounted on so-called solar trackers. The latter are devices used to orient PV panels, reflectors, lenses or other optical devices toward the sun. Since the sun's position in the sky changes with the seasons and the time of day, trackers are used to align the collection system to maximize energy production. There are many types of solar trackers, of varying costs, sophistication, and performance. The two basic categories of trackers are single axis and dual axis. Single axis solar trackers can either have a horizontal or a vertical axis. Dual axis solar trackers have both a horizontal and a vertical axis and thus they can track the sun's apparent motion virtually anywhere in the sky. However, such trackers are large, heavy and very complex structures. They require frequent maintenance and have reliability issues related to wind load or humidity. Moreover, due to their size, weight and form factor, these trackers cannot be mounted on rooftops and thus cannot address the need of solar panels for the residential market, where high efficiency is key due to the limited area available.

Even when combined with a tracker, CPV systems can only efficiently concentrate collimated (directional) light, such as light coming directly from the sun. Diffuse sunlight coming from all points of the sky at the same time, as well as light reflected by the environment, cannot be efficiently concentrated by the optical arrangement and will therefore not be transmitted to and collected by the high efficiency PV cells. Although diffuse irradiance is typically only a small fraction of the total irradiance on a sunny day, the total amount of diffuse irradiance on a yearly basis can be very significant depending on the geographical location and local climate.

In order to overcome or diminish the above drawbacks, hybrid architecture CPV systems comprising secondary type solar cells have been developed. The secondary cells are typically silicon solar cells having a larger surface area than the primary cells and are disposed either around the primary cells or below them, in such a way that the secondary cells can collect some of the light which is not collected by the primary cells and that would otherwise be lost. Thanks to this architecture, more light can be collected and transformed to electricity. The nominal output power and the total energy yield of the solar concentrating module can be significantly increased.

For all the above reasons, there is a need for an optomechanical system with hybrid architecture providing primary high efficiency elements for the conversion of mostly direct concentrated light energy and secondary elements for the conversion of additional light not converted by the primary elements, and further comprising a shifting mechanism that moves only within a limited volume, in order to track the apparent movements of the sun while still ensuring compatibility with fixed-tilt installations such as rooftops.

Furthermore, there remains a need for a system which is reliable and requires a minimal maintenance over an extended lifetime. For instance, a system with at least 20 years of lifetime is expected.

### Summary of the invention

Thus, the object of the present invention is to propose a new optomechanical system and a corresponding method for converting light energy, in which the above-described drawbacks of the known systems and methods are completely overcome or at least greatly diminished.

An object of the present invention is in particular to propose an optomechanical system and a corresponding method for converting light energy, thanks to which it is possible to transform the light energy emerging from highly directional sources, as for instance the sun, but also to transform the light energy from diffuse sources, as for instance the sky, and thus to maximize the energy output of the system.

According to the present invention, these objects are achieved in particular through the elements of the two independent claims. Further advantageous embodiments arise from the dependent claims and the description. Features disclosed herein in different embodiments can also be combined easily by a person who is skilled in the art.

In particular, in a first aspect, the objects of the present invention are achieved by an optomechanical system for converting light energy, comprising
▪ an optical arrangement comprising one or more optical layers, wherein at least one of the optical layers comprises a plurality of primary optical elements to concentrate incident light into transmitted light;
▪ a light energy conversion layer;
▪ a shifting mechanism for moving at least one of the optical layers of the optical arrangement relative to the light energy conversion layer or vice versa; and
▪ a frame element to which either the optical arrangement or the light energy conversion layer is attached,
wherein the light energy conversion layer comprises a plurality of primary light energy conversion elements and a plurality of secondary light energy conversion elements capable of converting the energy of the transmitted light into an output energy, wherein the primary light energy conversion elements and the secondary light energy conversion elements differ by type, and/or surface area, and/or light conversion efficiency, and/or light conversion spectrum, and wherein the output energy types of the primary light energy conversion elements and of the secondary light energy conversion elements can be different, and
wherein the shifting mechanism is arranged to move at least one of the layer of the optical arrangement or the light energy conversion layer translationally relative to the frame element, through one or more translation element in such a way that the total output power of the primary light energy conversion elements and of the secondary light energy conversion elements can be adjusted.

Thanks to the present invention, it is possible to efficiently transform the light energy emerging from highly directional light sources and from diffuse light sources at the same time. With this optomechanical system it is possible to transform more light energy and the nominal output power and the total energy yield of the optomechanical system can be significantly increased.

The shifting mechanism of the optomechanical system can be used to distribute light between the two or more types of light absorbing elements. In some cases when incident light can be significantly concentrated (e.g. when incident light is mostly direct or collimated), it can be advantageous to focus most of the transmitted light to high efficiency primary light energy conversion elements. When incident light is more diffuse and cannot be concentrated on a small area, it can be advantageous to distribute transmitted light mostly on the secondary light energy conversion elements, which are typically less efficient at converting light to other forms of energy, but have a much larger surface area than the primary absorbing elements.

When the optomechanical system of the present invention is used with sunlight and a combination of high-efficiency and traditional PV cells, the present invention allows for a significant reduction in costs because the overall surface area of the high-efficiency PV cells can be significantly reduced with respect to systems which do not comprise the described optomechanical system of the present invention. Consequently, the efficiency of the system is greatly increased without resulting in prohibitive costs. The optomechanical system ensures that most of direct sunlight is transmitted to the high efficiency PV cells and that the light not captured by the high-efficiency PV cells (i.e. diffuse light or direct light with large incidence angles) is transmitted to the larger area traditional PV cells. Since the latter mostly collect diffuse sunlight or light with low concentration factors, the design of the secondary light energy conversion elements can be optimized to maximize efficiency at low to medium irradiance levels (e.g. typically 100 to 500 Watts per meter square).

In one preferred embodiment of the present invention, the shifting mechanism is arranged to move at least one of the layer of the optical arrangement or the light energy conversion layer in such a way that the total output energy power of the primary light energy conversion elements and of the secondary light energy conversion elements can be maximized.

In a further embodiment, the primary optical elements are of reflective type such as mirrors or of refractive type such as lenses including plano-convex, plano-concave, bi-convex, bi-concave, meniscus type and aspheric curvature having polynomial shape. Optical elements such as lenses with aspheric curvature, advantageously with an aspheric curvature described by a polynomial of order 3 or higher, and in particular aspheric curvature including one or more inflection points, allow for a higher design freedom to increase the angular acceptance and reduce optical aberrations. This allows for efficiently concentrating the light emerging from a highly directional source, such as the sun, onto high-efficiency light energy conversion elements. Thanks to concentration, the area of expensive light energy conversion elements can be reduced, thus decreasing the cost. Furthermore, concentration typically increases the efficiency of the light energy conversion elements.

In another preferred embodiment, the optomechanical system is configured such that direct sunlight is directed by means of the primary optical elements to the primary light energy conversion elements and such that diffuse sunlight is captured by the secondary light energy conversion elements.

In another preferred embodiment, the primary light energy conversion elements and/or the secondary light energy conversion elements are photovoltaic cells. With this, electricity can be efficiently and directly produced by the optomechanical system.

In yet another preferred embodiment, both the primary light energy conversion elements and the secondary light energy conversion elements are single-junction photovoltaic cells, of different types.

In yet another preferred embodiment, the primary light energy conversion elements and secondary light energy conversion elements are photovoltaic cells of the same type, wherein the primary light energy conversion elements and secondary light energy conversion elements differ in surface area and/or shape. In this embodiment, the primary and secondary light energy conversion elements are preferably made from the same source wafer, which is then partitioned by trenches or slots to define the contours of the primary and secondary light energy conversion elements. The partitioning process advantageously defines smaller areas for the primary light energy conversion elements primarily designed to convert highly-localized concentrated light, and larger areas for the secondary light energy conversion elements primarily designed to convert diffuse and thus non-localized light. This embodiment is advantageous to manufacture both type of cells from the same source material, while still benefiting from the efficiency increase provided by light concentration on the primary light energy conversion elements.

In yet another preferred embodiment, the primary light energy conversion elements are multi-junction photovoltaic cells and the secondary light energy conversion elements are photovoltaic cells of another type. Multi-junction photovoltaic cells are very efficient but expensive while single-junctions PV cells are less efficient but much cheaper. The primary light energy conversion elements can advantageously be triple-junction cells based on III-V semiconductors, such as GaInP/GaInAs/Ge or InGaP/GaAs/GaInAsNSb, which can reach efficiencies of more than 40% under concentration. Alternatively, the primary light energy conversion elements can be dual-junction cells or tandem cells, such as perovskites-silicon tandem cells, which have the potential to offer better performance-to-cost ratios. It should be noted that the junctions of the multi-junction cells can be grown by epitaxial processes or stacked mechanically. The secondary light energy conversion elements can advantageously be mono-crystalline silicon cells, poly-crystalline silicon cells, or thin-film solar cells such as Copper Indium Gallium Selenide (CiGS), Cadmium Telluride (CdTe) or amorphous silicon, which are all mass-produced at very low cost. Nonetheless, they can also be made from other technologies/materials such as hetero-junction silicon cells or perovskites. With the right balance, in terms of surface area and cost for instance, between the primary and secondary light energy conversion elements, the yield of the system can be maximized.

In another embodiment, the primary light energy conversion elements are photovoltaic cells and the secondary light energy conversion elements are thermal solar collectors. This is advantageous to provide an optomechanical system generating two type of energy outputs (electricity and heat), which can be beneficial in applications such as residential solar installations.

In a further preferred embodiment, the secondary light energy conversion elements are provided with holes into which the primary light energy conversion elements can be placed, wherein the secondary light energy conversion elements cover the surface of the light energy conversion layer between the primary light energy conversion elements. Thanks to this architecture, the primary and the secondary light energy conversion elements can be arranged in a same plane. With the secondary light energy conversion elements covering the surface of the light energy conversion layer between the primary light energy conversion elements, the light not captured by the latter is captured by the secondary elements.

In another preferred embodiment of the present invention, the light energy conversion layer comprise a primary light energy conversion layer and a secondary light energy conversion layer mounted on top of each other in direction of the optical arrangement, wherein the primary light energy conversion layer carries the primary light energy conversion elements and the secondary light energy conversion layer carries the secondary light energy conversion elements. With this architecture, the primary and secondary light energy conversion elements are located in two different planes. This arrangement is advantageous for ease of assembly, since the primary light energy conversion layer can be mounted directly on top of a secondary light energy conversion layer without major change to the structure of the latter. Furthermore, with this arrangement, the secondary light energy conversion layer is not degraded by machining (e.g. holes) and the surface available for the secondary light energy conversion elements is maximized. Additionally, the heat generated by the light energy not converted by the primary or secondary energy conversion elements is spread on two different planes, which allows for better temperature distribution in the light energy conversion layer. For instance, when the primary light energy conversion elements are multi-junction photovoltaic cells and the secondary light energy conversion elements are single junction photovoltaic cells, the efficiency of the latter is more negatively impacted by temperature increase since their temperature coefficient is larger. By using the aforementioned architecture, the heat generated by concentrated direct light is localized on the primary light energy conversion elements and the impact on the secondary light energy conversion elements is minimized.

In a further preferred embodiment of the present invention, the primary light energy conversion layer is provided with primary light energy conversion elements designed to convert a specific range of wavelength of the transmitted light, advantageously short wavelengths from UV to visible light, while the rest of the transmitted light, advantageously short wavelengths from UV to visible light (with longer wavelengths such as infrared light) is further transmitted through the primary light energy conversion layer to be converted by the secondary light energy conversion elements. This embodiment is advantageous to decrease the cost of the primary light energy conversion layer, by using cheaper light energy conversion elements capable of converting only part of the transmitted light spectrum, while the secondary light energy conversion layer converts the rest. Advantageously, the primary light energy conversion layer can be made from a diffusive material or provided with reflective elements designed to spread the transmitted light and increase the illumination homogeneity on the secondary light energy conversion elements, avoiding hot spots and thus increasing light energy conversion efficiency.

In a further preferred embodiment of the present invention, the primary light energy conversion layer is provided with holes arranged such that at least part of the transmitted light can reach the secondary light energy conversion elements. In that way, the light not captured and transformed by the primary light energy conversion elements can be captured and transformed by the secondary light energy conversion elements.

In a further preferred embodiment of the present invention, the primary light energy conversion layer is made of a transparent dielectric. In this arrangement, the light not captured and transformed by the primary light energy conversion elements is transmitted through the transparent dielectric to be captured and transformed by the secondary light energy conversion elements. The transparent dielectric is advantageously made from a material with very high optical transmission in the range of wavelengths that can be converted by the secondary light conversion elements, such as low-iron float glass, advantageously with anti-reflective coating or patterning. The transparent dielectric can be laminated on top of the secondary light energy conversion layer using a transparent encapsulant such as Ethylene-Vinyl Acetate (EVA). The transparent dielectric can also be a thin layer grown directly on top of the secondary light energy conversion elements, such as silicon oxide grown on top of PV cells.

In another preferred embodiment of the present invention, the primary light energy conversion elements are interconnected by primary electrical connections lines. The primary electrical connections lines provide a means to combine the outputs of the primary light energy conversion elements into a single power output.

In another preferred embodiment of the present invention, the primary connection lines are provided on the transparent dielectric. With this light not captured by means of the primary light energy conversion elements can reach the secondary light energy conversion elements.

In yet another preferred embodiment of the present invention, the primary connections lines are made out of a transparent conductive material, such as a transparent conductive oxide. This embodiment is advantageous to combine the outputs of the primary light energy conversion elements into a single power output while guaranteeing that the light absorbed by these connection lines is minimal. This ensures that the maximum of light not captured by the primary light energy conversion elements is transmitted to and captured by the secondary light energy conversion elements.

In another preferred embodiment of the present invention, the secondary light conversion elements are interconnected by secondary connection lines with a geometry designed to minimize energy losses due to shading and/or scattering.

In one preferred embodiment, the output terminals of each of the primary light energy conversion elements are interconnected by electrically conductive lines with a combination of series and parallel connections, to provide a primary two-terminal output and/or the output terminals of each of the secondary light energy conversion elements are interconnected by electrically conductive lines with a combination of series and parallel connections, to provide a secondary two-terminal output. With this the optomechanical system can be provided with a four-terminal output. This embodiment is advantageous to provide a high flexibility for maximum power point optimization, since the power point of the primary and secondary outputs can be adjusted independently.

In another preferred embodiment, one of the terminals of the primary power output and one of the terminals of the secondary power output are connected, so that the optomechanical system is provided with a three-terminal output.

In a further preferred embodiment, the primary and secondary power outputs are combined using power electronics so that the optomechanical system is provided with a two-terminal power output. This is advantageous to minimize the number of external interconnections, for instance on a setup/installation where multiple optomechanical systems are combined.

In a further preferred embodiment of the present invention, the secondary light energy conversion elements are bifacial. This permits to capture and transform light energy incident to the backside of the system.

In a further preferred embodiment of the present invention, the secondary light energy conversion elements are chosen for the conversion of the energy of a specific portion of the solar spectrum, advantageously the blue spectrum. Since the spectrum of diffuse light coming from the sky dome is typically shifted towards blue, the secondary light energy conversion elements can advantageously be optimized to be more efficient at converting light in the blue part of the spectrum.

It should be noted that the substrates on which the primary and secondary light energy conversion elements are mounted, i.e. the primary light energy conversion layer and the secondary light energy conversion layer, can be made of various materials, such as, but not limited to: aluminum, steel, stainless steel, glass, ABS, PMMA (acrylic), or carbon fiber. Depending on the architecture/embodiment, some of these materials can be more advantageous than others. For instance, with bifacial light energy conversion elements, the material chosen for the substrate will advantageously be of a highly transparent type, such as glass or transparent polymers. In order to maintain an optimal alignment between the primary optical elements and the corresponding primary light energy conversion elements, the materials of the optical layer and the light energy conversion layer advantageously have similar or compatible thermal expansion coefficients.

In another preferred embodiment of the present invention, secondary optical elements of refractive type and/or of reflective type are provided directly onto the primary light energy conversion elements. The secondary optical elements mounted directly on the primary light energy conversion elements have two main advantages. Firstly, they ensure a better collection of transmitted light by the primary light energy conversion elements since the secondary optical elements allow for the collection of a portion of the light that would otherwise miss the primary light energy conversion elements and be lost or transmitted to the secondary light energy conversion elements, which are less efficient at converting light to electrical power. Secondly, the secondary optical elements allows for increasing the alignment tolerance. In case several primary light energy conversion elements are mounted on the same substrate, the light concentrated and transmitted by each primary optical element of the optical arrangement can be slightly misaligned. The secondary optical elements minimize the losses related to this misalignment.

In a further preferred embodiment, tertiary optical elements are provided on top of the light energy conversion layer in direction of the optical arrangement, wherein tertiary optical elements are configured such that the amount of light impinging on a light converting area of the light energy conversion layer is maximized. The tertiary optical elements allow for instance to modify the path of the light that otherwise would impinge on the connection lines of the primary light energy conversion elements and thus would be lost. Thanks to the tertiary optical elements, this light is redirected for instance to the secondary light energy conversion elements.

In another embodiment of the present invention, the optomechanical system further comprises one or more sliders, arranged between the light energy conversion layer and the optical arrangement, and one or more pre-constraining elements. The one or more slider can be fixed on either of its ends and sliding on the other, or it can be arranged to slide on both ends. For instance, the sliders can be fixed to the optical arrangement on one end and sliding on the light energy conversion layer on the other end, or vice-versa. A pre-constraining element, such as a spring, can be arranged on the same axis as the sliders, to ensure that the sliders are always in contact with the surface they are sliding on. With an appropriate number of sliders, the distance between the optical arrangement and the light energy conversion layer can be accurately and reliably preserved over the whole surface of the optomechanical system. Furthermore, the rigidity of the optomechanical system on the axis perpendicular to the surface of the optical arrangement is greatly increased, lowering the rigidity requirements on other guiding elements of the shifting mechanism.

In a further embodiment, some sliding pads can be arranged between the sliders and the surface they are sliding on, in order to reduce friction and/or to locally change the slope of the surface on which the sliding occurs. More specifically, the sliding pads can have any desired curvature, for instance a portion of sphere, in such a way that when the slider is moving laterally on the sliding pad, the distance between the optical arrangement and the light energy conversion layer is changing according to the desired curvature. Otherwise said, a lateral displacement induces a controlled vertical displacement. This configuration is advantageous to increase the efficiency and/or the angular acceptance of the optomechanical system.

In another preferred embodiment, the shifting mechanism further comprises one or more guiding elements, for instance one or more flexible guiding elements, such as a spring or leaf spring, in such a way that the one or more guiding elements are capable of limiting the degrees of freedom of the optical arrangement and/or of the light energy conversion layer. Advantageously, the one or more guiding elements, advantageously flexible guiding elements, capable of limiting the degrees of freedom of the one or more translation elements are arranged in such a way that the relative position of the optical arrangement and the light energy conversion layer can be accurately adjusted by the shifting mechanism, and more specifically avoiding or minimizing relative rotations. In this manner, the shifting mechanism ensures that the relative movement of the optical arrangement and the light energy conversion layer occurs only in translation, without rotation. Flexible guiding elements based on mechanical deformation are advantageous for mechanical systems requiring high reliability and long lifetime, such as the optomechanical system of the present invention, since they do not involve friction and do not suffer from wear. In addition, their rigidity in the direction perpendicular to the movement and their precision in carrying out small displacements qualify them particularly for this type of systems.

In a further embodiment, the one or more guiding elements are capable of suppressing rotational movement between the optical arrangement and the light energy conversion layer. This is of particular importance since any spurious rotational movement between the optical arrangement and the light energy conversion layer results in a decrease of the output power of the system.

In another preferred embodiment of the present invention, the light energy conversion layer is directly attached to the optical arrangement by means of guiding elements such as double universal joints, in particular double cardan joints or double ball joint, and/or by means of flexible guiding elements such as a spring, leaf spring or flexible rod. The direct mechanical link provided by these guiding elements ensures a more accurate positioning of the optical arrangement and the light energy conversion layer relative to each other.

In a further preferred embodiment of the present invention, the guiding elements are arranged to guide the movement of the optical arrangement or the light energy conversion layer on a paraboloid or on a spherical trajectory. With this, the primary light energy conversion elements can be positioned at the focal point of the primary optical elements independently of the angle of incidence of the incident light. Furthermore, a curved displacement trajectory can be advantageous to increase the efficiency and/or the angular acceptance of the optomechanical system.

In another preferred embodiment of the present invention, the optical arrangement comprises at least two optical layers bonded to each other, either directly or by means of an adhesive layer.

In yet another preferred embodiment of the present invention, one of the optical layers is made out of a rigid material, such as glass or acrylic (PMMA), and one of the optical layers is made of a flexible material, such as silicone rubber. In this embodiment, the front optical layer, the one farthest from the light energy conversion layer, is made of a relatively rigid material, such as glass or acrylic (PMMA), to increase the rigidity of the optical arrangement and protect the subsequent optical layers from mechanical shocks or environmental pollution (such as dust or humidity). The front optical layer is typically flat, i.e. without optical elements, but it can be also patterned to alter the path or distribution of transmitted light. Furthermore, the front optical layer can be coated with a single- or double-sided anti-reflective coating to improve light transmission

In a further preferred embodiment of the present invention, the optical layers are formed by molding, in particular by injection or compression molding. Molding is a particular simple and cheap method for producing the optical layers while allowing for a high optical precision.

In a further preferred embodiment of the present invention, the primary optical elements have a hexagonal or rectangular tiling contour and are arranged in an array. This permits to cover completely the surface of the optical arrangement with the primary optical elements without having any gap between these elements.

In one preferred embodiment, the optical arrangement is attached to the front side of the frame element, forming together a closed box which surrounds completely the light energy conversion layer and the shifting mechanism. With this influences from environmental factors, such as mechanical shocks, wind load or humidity, are minimized.

In a further embodiment the optical arrangement incorporates a venting system to prevent excessive pressure to build up and/or water condensation to occur within the closed space defined by the frame element and the optical arrangement when the external conditions are changing, for instance a temperature change. The lifetime and reliability of the system can thus be increased.

In a further preferred embodiment, the translation element of the shifting mechanism comprises at least one actuator and a control system, such that at least one optical layer of the optical arrangement or the light energy conversion layer can be moved in one or more degrees of freedom in a translational movement. The translational movement may be configured in one, two or three degrees of freedom accordingly. Higher degree of freedom in translation could increase the accuracy and sensitivity of the system, so that the yield of the system can be maximized.

In another preferred embodiment of the present invention, the shifting mechanism comprises two or more actuators disposed in parallel to the same translational axis but at opposite ends of the translation element and one or more actuators disposed in a direction perpendicular to the first two. This configuration allows to cancel any parasitic rotation of the translation element around an axis normal to the optical arrangement, in order to ensure that there is no relative rotation between the light energy conversion layer and the optical arrangement.

According to one embodiment, the actuator is an electro-mechanical actuator, an electro-static actuator, a piezo-electrical actuator, a stick-slip actuator or a pneumatic actuator.

According to a further embodiment, the optomechanical system of the invention further comprises a feedback control loop to monitor the position of the translation element and/or the output power of the system, wherein the feedback control loop is for example an optical sensor, a magnetic sensor or a photovoltaic sensor, a power meter, or a combination of several of these sensors. The one or more sensors can report information on the relative or absolute position of the translation element, the optical arrangement, or the light energy conversion layer, or a combination thereof, or on the output power of the system such that the light energy conversion yield can be optimized.

In another embodiment of the present invention, the frame is at least partially open at the bottom and a flexible membrane seals the gap between the translation element and the frame while allowing the translational element to move both laterally and vertically. In this configuration, the translation element and with it the light energy conversion layer are directly exposed to ambient temperature which allows the heat to be dissipated by convection.

In a second aspect, the present invention relates to a method for converting light energy with an aforementioned optomechanical system, comprising the steps of:
▪ concentrating incident light into transmitted light;
▪ converting the energy of the transmitted light into an output energy by means of the primary light energy conversion elements and the secondary light energy conversion elements; and
▪ moving at least one of the optical layers of the optical arrangement relative to the light energy conversion layer or vice versa,
wherein the shifting mechanism moves the at least one of the optical layers of the optical arrangement or the light energy conversion layer translationally by one or more translation element in such a way that the total output energy power of the primary light energy conversion elements and of the secondary light energy conversion elements is maximized.

It is to be noted that the term "concentrating" does not imply that the incident light is fully concentrated. As mentioned above, most of direct incident sunlight is transmitted to the high efficiency PV cells in one layer. However, the light not captured by the high-efficiency PV cells (i.e. diffuse light or direct light with large incidence angles) is transmitted to the larger area traditional PV cells in another layer.

### Brief description of the drawings

The foregoing and other objects, features and advantages of the present invention are apparent from the following detailed description taken in combination with the accompanying drawings in which:
Fig. 1A is a schematic cross-sectional view of the optical arrangement and of the light energy conversion layer according to a first embodiment of the present invention, where high directional light is impinging normally onto the optical arrangement;
Fig. 1B is a schematic cross-sectional view of the optical arrangement and of the light energy conversion layer according to a first embodiment of the present invention, where high directional light is impinging with a small incidence angle onto the optical arrangement;
Fig. 1C is a schematic cross-sectional view of the optical arrangement and of the light energy conversion layer according to a first embodiment of the present invention, where high directional light is impinging with a large incidence angle onto the optical arrangement;
Fig. 1D is a schematic cross-sectional view of the optical arrangement and of the light energy conversion layer according to a first embodiment of the present invention, where only diffuse light is present;
Fig. 2A presents a schematic side view of an arrangement of the primary light energy conversion elements and the secondary light energy conversion elements according to a second embodiment of the present invention;
Fig. 2B presents a schematic top view of an arrangement of the primary light energy conversion elements and the secondary light energy conversion elements according to the second embodiment of the present invention;
Fig. 2C presents a schematic side view of an arrangement of the primary light energy conversion elements and the secondary light energy conversion elements according to a third embodiment of the present invention;
Fig. 2D presents a schematic top view of an arrangement of the primary light energy conversion elements and the secondary light energy conversion elements according to the third embodiment of the present invention;
Fig. 2E presents a schematic side view of an arrangement of the primary light energy conversion elements and the secondary light energy conversion elements according to a fourth embodiment of the present invention;
Fig. 2F presents a schematic top view of an arrangement of the primary light energy conversion elements and the secondary light energy conversion elements according to the fourth embodiment of the present invention;
Fig. 2G presents a schematic side view of an arrangement of the primary light energy conversion elements and the secondary light energy conversion elements according to a fifth embodiment of the present invention;
Fig. 2H presents a schematic top view of an arrangement of the primary light energy conversion elements and the secondary light energy conversion elements according to the fifth embodiment of the present invention;
Fig. 2I presents a schematic side view of an arrangement of the primary light energy conversion elements and the secondary light energy conversion elements according to a sixth embodiment of the present invention;
Fig. 2J presents a schematic side view of an arrangement of the primary light energy conversion elements and the secondary light energy conversion elements according to a seventh embodiment of the present invention;
Fig. 3 shows a tiling of the optical arrangement with hexagonal primary optical elements, according to a seventh embodiment of the present invention;
Figs. 4A and 4B show secondary optical elements directly mounted on the primary light energy conversion elements according to an eighth embodiment of the present invention;
Fig. 5 shows tertiary optical elements directly mounted on top of the primary light energy conversion elements according to an ninth embodiment of the present invention;
Fig. 6 shows tertiary optical elements mounted on top of the connection lines of primary light energy conversion elements according to a tenth embodiment of the present invention;
Fig. 7 presents an architecture of the connection lines of the primary light energy conversion elements and of the secondary light energy conversion elements according to a eleventh embodiment of the present invention;
Fig. 8 is a schematic cross-sectional view of the optical arrangement and of the light energy conversion layer according to a twelfth embodiment of the present invention, where the secondary light energy conversion elements are bifacial;
Fig. 9 is a schematic top view of an optomechanical system according to a thirteenth embodiment of the present invention;
Fig. 10 is a schematic cross-sectional view of an optomechanical system according to a fourteenth embodiment of the present invention where the optical arrangement comprises one movable optical layer and one static optical layer;
Fig. 11A is a schematic cross-sectional view of an optomechanical system according to a fifteenth embodiment of the present invention where the optical arrangement comprises only one static optical layer and the light energy conversion layer is movable;
Figs. 11B and 11C are schematic cross-sectional views of the shifting mechanism of an optomechanical system according to the fifteenth embodiment of the present invention (corresponding to Fig. 11A);
Fig. 12A is a schematic cross-sectional view of an optomechanical system according to a sixteenth embodiment of the present invention where the light energy conversion layer is movable and the optical arrangement comprises two static optical layers;
Fig. 12B is a detailed schematic cross-sectional view of the optical arrangement according to a seventeenth embodiment of the present invention where the optical arrangement is composed of two optical layers directly bonded together;
Fig. 12C is a detailed schematic cross-sectional view of the optical arrangement according to an eighteenth embodiment of the present invention where the optical arrangement is composed of two optical layers bonded together by means of an adhesive layer;
Fig. 12D is a schematic cross-sectional view of an optomechanical system according to a nineteenth embodiment of the present invention with a movable light energy conversion layer and with sliders and a pre-constraining element to maintain a constant distance between the light energy conversion layer and the optical arrangement.
Fig. 12E is a schematic cross-sectional view of an optomechanical system according to the same embodiment as Fig. 12D, but where the first optical layer is composed of several blocks in order to be able to increase the number of sliders.
Fig. 12F is a detailed schematic cross-sectional view of the optomechanical system according to a twentieth embodiment where sliding pads are arranged between the sliders and the optical arrangement;
Fig. 12G is a schematic cross-sectional view of an optomechanical system according to a twenty-first embodiment of the present invention with a movable light energy conversion layer, attached directly to the optical arrangement by means of guiding elements;
Fig. 12H represents the same embodiment as Fig. 12G but where the movable light energy conversion layer, attached directly to the optical arrangement by means of guiding elements, has been shifted by the shifting mechanism;
Fig. 12I represents the same embodiment as Fig. 12G but with a plurality of guiding elements and an optical layer composed of several blocks;
Fig. 12J is a schematic cross-sectional view of an optomechanical system according to a twenty-second embodiment of the present invention with a partially opened frame at the bottom;
Fig. 13A is a schematic cross-sectional view of the optical arrangement and of the light energy conversion layer of the optomechanical system according to twenty-third embodiment of the present invention where the guiding elements are moulded with the optical arrangement;
Fig. 13B is a schematic cross-sectional view of the optical arrangement and of the light energy conversion layer of the optomechanical system according to the same embodiment as Fig. 13A but where the optical arrangement has been shifted;
Fig. 14 is a schematic top view of an optomechanical system according to a twenty-third embodiment of the present invention.

### Detailed description of the preferred embodiments of the invention

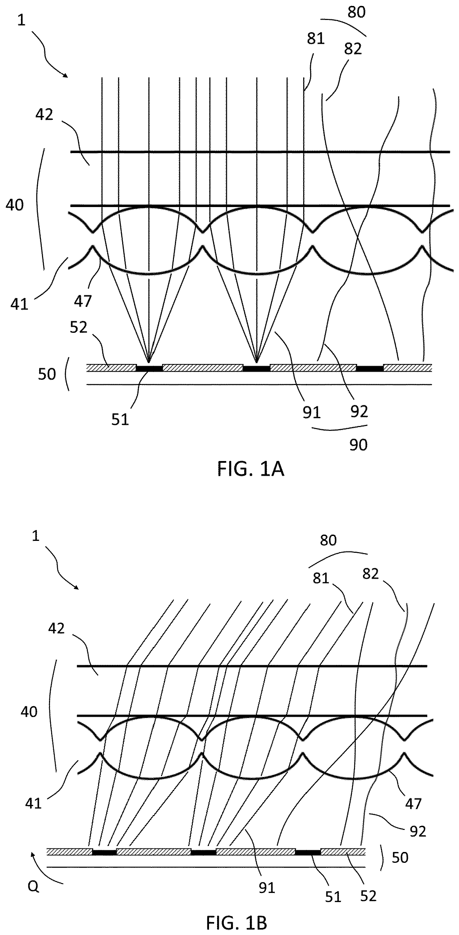

Figures 1A to 1D are schematic cross-sectional detailed views of a photovoltaic optomechanical system with hybrid architecture 1 according to a first embodiment of the present invention. The photovoltaic optomechanical system with hybrid architecture 1 comprises a light energy conversion layer 50 with the primary light energy conversion elements 51, here advantageously high-efficiency PV cells, and the secondary light energy conversion elements 52, advantageously here conventional PV cells based for instance on silicon technology, and an optical arrangement 40. The optical arrangement 40 comprises one primary optical layer 41 and one secondary optical layer 42. In this embodiment, the optical layer 42 takes the form of a cover that could be also omitted without departing from the frame of the present invention. In the case where the optical layer 42 is omitted, the optical layer 41 acts itself as cover. As illustrated in Figure 1A, when the incident light 80 comprises a highly directional light component 81 which impinges normal to the optical layer 41 and the light conversion layer 50, the optomechanical system 1 is configured such that the highly-directional light component incident light 81 is concentrated, by means of primary optical elements 47 of the optical arrangement, into transmitted light 91 which is focused on the high-efficiency solar cells 51. The diffuse incident light component 82 is only redirected by the primary optical elements 47 and impinges mainly on the traditional PV cells 52. As one can easily understand from this Figure, the present invention permits to capture and convert effectively light energy emerging from a high-directional light source, as the sun, but also light energy emerging from a diffuse light source, as the for instance the sky.

As shown in Figure 1B, highly-directional incident light 81 with an incidence angle different than zero is still concentrated by the optical layer. Thanks to a shifting mechanism that is able to move the light energy conversion layer 50 in the direction X, Y and Z (cf. below for more details on the possible embodiments of the shifting mechanism), the primary light energy conversion elements 51 are positioned at the focal points of the primary optical elements 47 of the optical arrangement 40 and can still collect most of the highly-directional light 81. Diffuse light 82 is as in the Figure 1A mainly collected by the traditional PV cells 52.

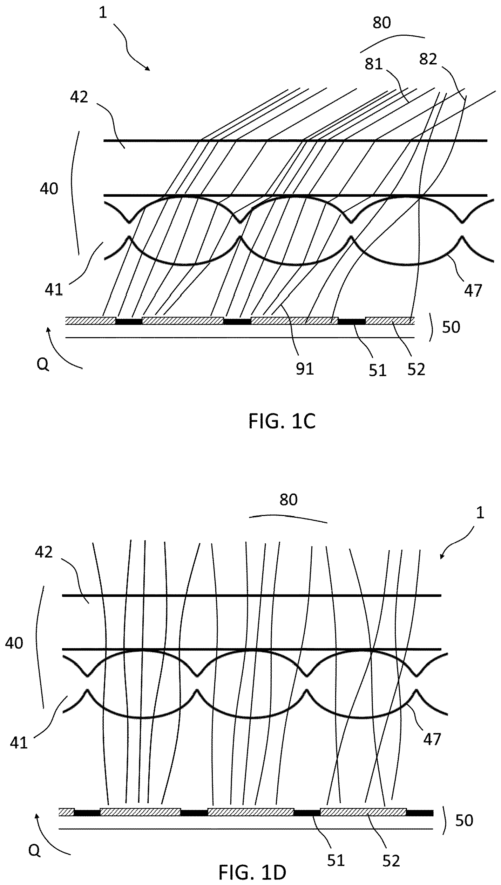

As can be seen in Figure 1C, at larger incidence angles, the primary optical elements 47 of the optical arrangement cannot focus the highly-directional incident light 81 solely on the high-efficiency PV cells 51 but a fraction of the energy of the highly-directional incident light 81 is captured and transformed by the secondary light energy conversion elements 52. With the PV cells 52, it is therefore possible to convert the light energy of the highly-directional light 81 even at very large incidence angles.

When incident light 80 is highly diffuse, i.e. the highly-directional component 81 of the incident light 80 is small, for instance on cloudy days, the optical arrangement 40 is unable to efficiently concentrate incident light 80 and the focal spots are much bigger than the primary light energy conversion elements 51. In this case, the shifting mechanism can position the light energy conversion layer 50 in such a way that most of the incident light 80 is transmitted to and can be collected by the secondary light energy conversion elements 52, as illustrated in Figure 1D.

Important to note is that the position of the light energy conversion layer 50 can be changed during a day and/or according to the lighting condition. In order to find the best position of the layer 50, it is advantageous to foresee one or more feedback sensors for the monitoring of the power output of the primary and secondary light conversion elements 51 and 52. The position of the layer 50 can thus be modified by means of the shifting mechanism to maximize the power output.

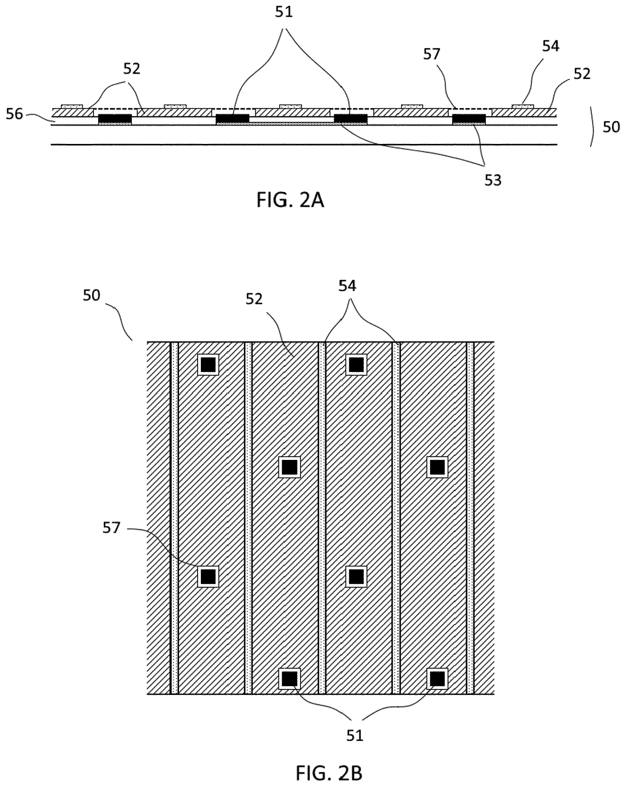

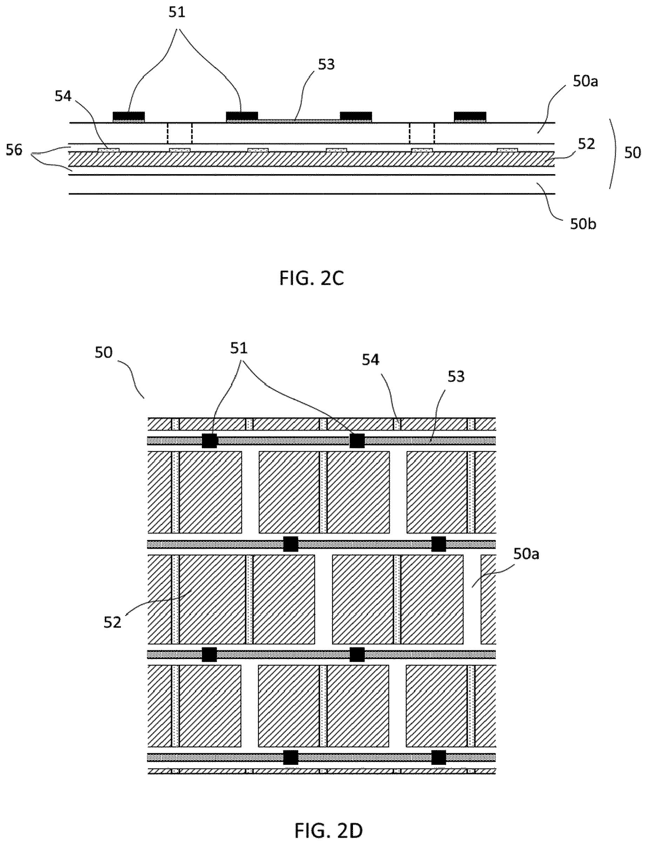

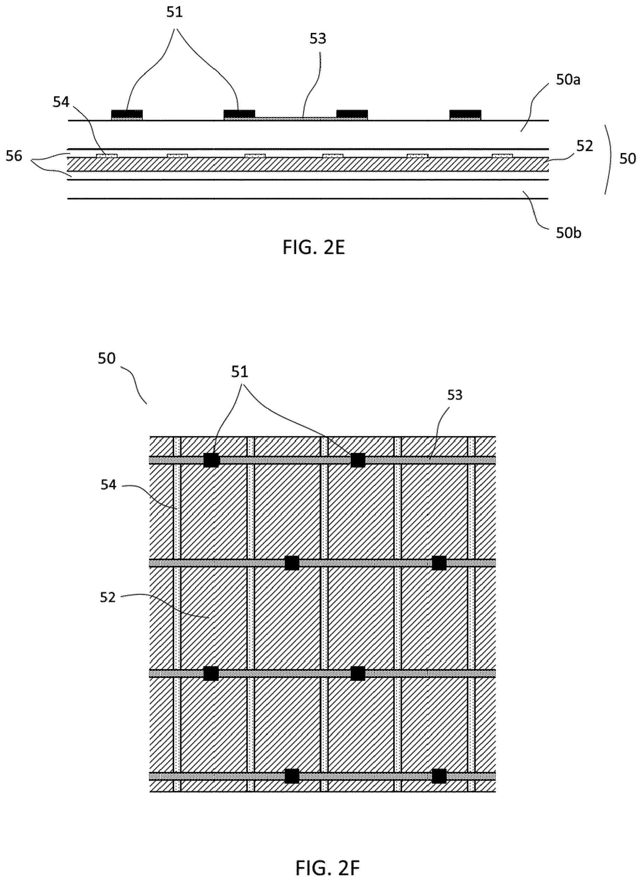

As mentioned above, the light energy conversion layer 50 comprises the primary light energy conversion elements 51 and the secondary light energy conversion elements 52. As shown in Figure 2A-2F these elements can be positioned in the layer 50 of different manners. In the embodiment of Figures 2A and 2B, the primary and secondary light energy conversion elements 51, 52 are mounted on the same substrate and thus in the same plane. Openings or cavities are machined into the secondary light energy conversion elements 52 for receiving the primary light energy conversion elements 51 without shading them. In the embodiment of Figures 2C and 2D, the light energy conversion layer 50 is subdivided in a primary light energy conversion layer 50a carrying the primary light energy conversion elements 51 and in a secondary light energy conversion layer 50b carrying the secondary light energy conversion elements 52. In this embodiment, the primary light energy conversion layer 50a takes the form of a grid-like substrate, which is mounted on top of the secondary light energy conversion layer 50b and thus the secondary light energy conversion elements 52 and their encapsulation 56. The openings or slots in the primary light energy conversion layer 50a allow transmitted light 91, 92 to reach the secondary light energy conversion elements 52. In the embodiment of Figures 2E and 2F, the primary light energy conversion elements 51 and their connection lines 53 are mounted on the primary light energy conversion layer 50a that takes the form here of a transparent substrate, which is then assembled on top of the secondary light energy conversion layer 50b and thus on top of the secondary light energy conversion elements 52 and their encapsulation. Advantageously, the connection lines 53 of the primary light energy conversion elements 51 are made of transparent electrically-conductive material, as for instance a conductive oxide. This permits to minimize the energy loss due to absorption of light energy by the connection lines 53.

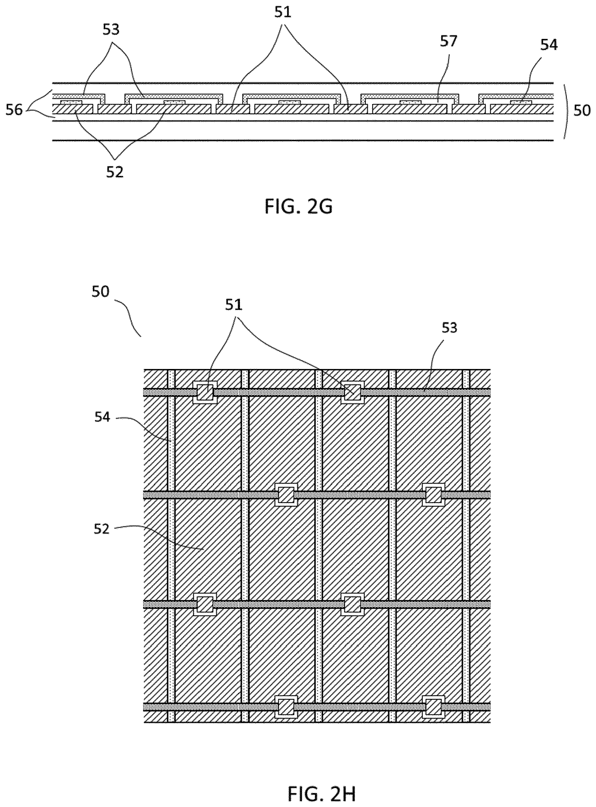

Figures 2G and 2H illustrate a further embodiment of the optomechanical system according to the present invention. Here, the primary light energy conversion elements 51 and secondary light energy conversion elements 52 are photovoltaic cells of the same type, wherein the primary light energy conversion elements 51 and secondary light energy conversion elements 52 differ in surface area and/or shape In this embodiment, the primary and secondary light energy conversion elements 51,52 are preferably made from the same source wafer, which is then partitioned by trenches or slots to define the contours of the primary and secondary light energy conversion elements. The partitioning process advantageously defines smaller areas for the primary light energy conversion elements 51 primarily designed to convert highly-localized concentrated light, and larger areas for the secondary light energy conversion elements 52 primarily designed to convert diffuse and thus non-localized light. This embodiment is advantageous to manufacture both type of cells from the same source material, while still benefiting from the efficiency increase provided by light concentration on the primary light energy conversion elements 51). As can be seen in these Figures, the primary light energy conversion elements 51 are electrically interconnected by means of connection lines 53. Similarly, the primary light energy conversion elements 52 are electrically interconnected by means of connection lines 54. In order to avoid a short circuit between the connection lines 53 and 54, a dielectric or an insulator 57 is arranged between them. Furthermore, an encapsulant 56 can be foreseen in order to isolate the light converting elements 51,52 and the connection lines from the surrounding.

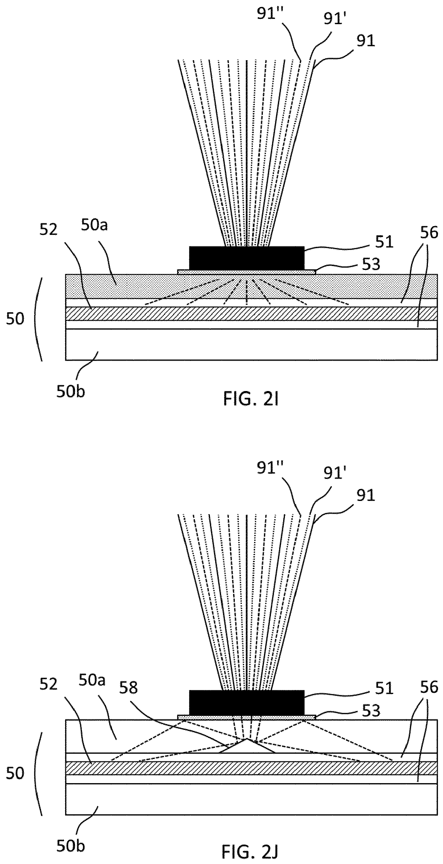

Figures 2I and 2J illustrate a further embodiment of the optomechanical system 1 according to the present invention, wherein the primary light energy conversion elements 51 and the secondary light energy conversion elements 52 are photovoltaic cells of two different types. The primary light energy conversion elements 51 are selected to convert only part of the direct light 91, 91' and 91" transmitted by the optical layer 40, while the rest of the transmitted light is further transmitted to the secondary light energy conversion elements 52. In this embodiment, the connection lines 53 are designed to be highly transparent to the light not converted by the primary light energy conversion elements 51. Furthermore, the primary light energy conversion layer 50a is made from a diffusive material as illustrated in Figure 2I or provided with reflective elements 58 as shown in Figure 2J designed to spread the transmitted light and increase the homogeneity of illumination on the secondary light energy conversion elements 52, in order to increase the light energy conversion efficiency.

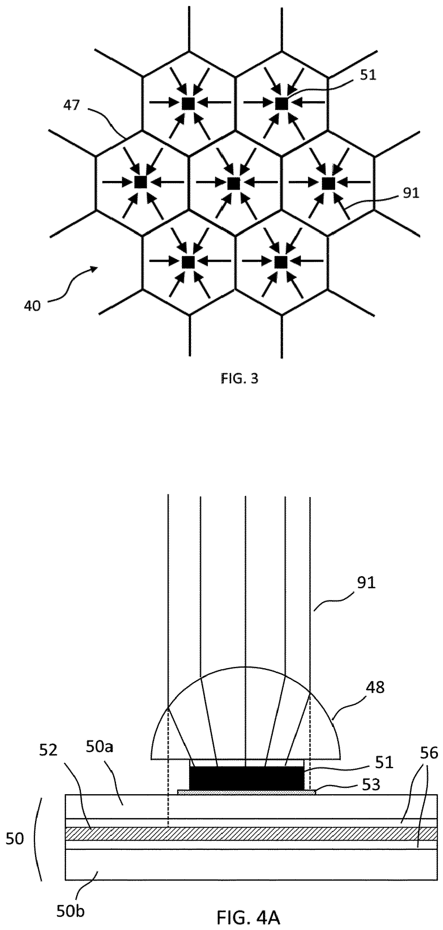

As illustrated in Figure 3, the optical arrangement 40 of the optomechanical system 1 comprises a plurality of primary optical elements 47 that can be foreseen in the first optical layer 41 and/or second optical layer 42. The primary optical elements can for instance be lenses or mirrors that have advantageously a hexagonal or a rectangular tiling contour. By this, the primary optical elements 47 can be arranged side-by-side and cover the entire surface of the optical arrangement 40 without any gaps.

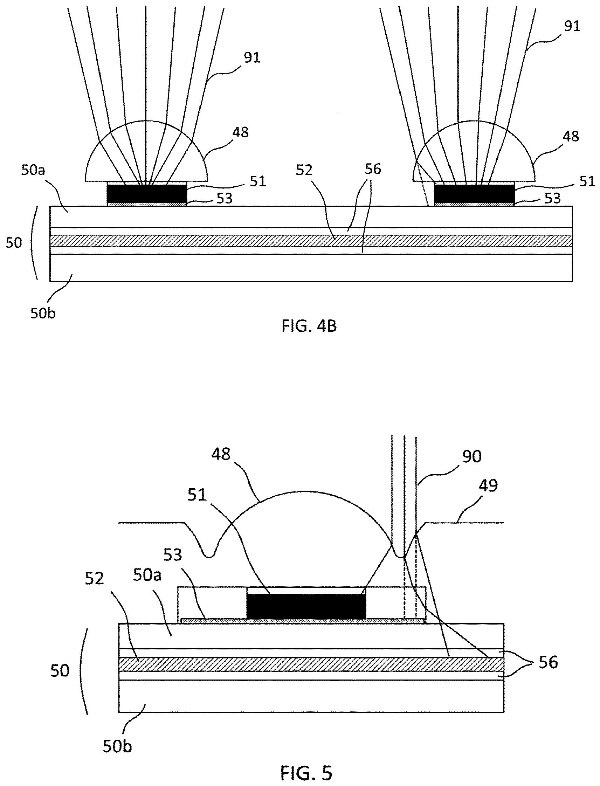

A further preferred embodiment of the present invention is shown in Figures 4A and 4B, where secondary optical elements 48 are mounted directly on the primary light energy conversion elements 51. In Figure 4A, the secondary optical elements 48 ensures a better collection of transmitted light 91 by the primary elements 51. As illustrated in Figure 4A, the optical elements 48 allows for the collection of a portion of the light 91 that would otherwise miss the primary light energy conversion element 51 and be lost or transmitted to the secondary light energy conversion elements 52, which are less efficient at converting light energy into another energy type.

As shown in Figure 4B, the secondary optical elements 48 increase also the alignment tolerance between the optical arrangement 40 and the light energy conversion layer. In case several primary light energy conversion elements 51 are mounted on the same substrate, the light concentrated and transmitted 91 by each primary optical element 47 of the optical arrangement 40 can be slightly misaligned. The secondary optical elements 48 allows for minimizing the losses related to the misalignment.

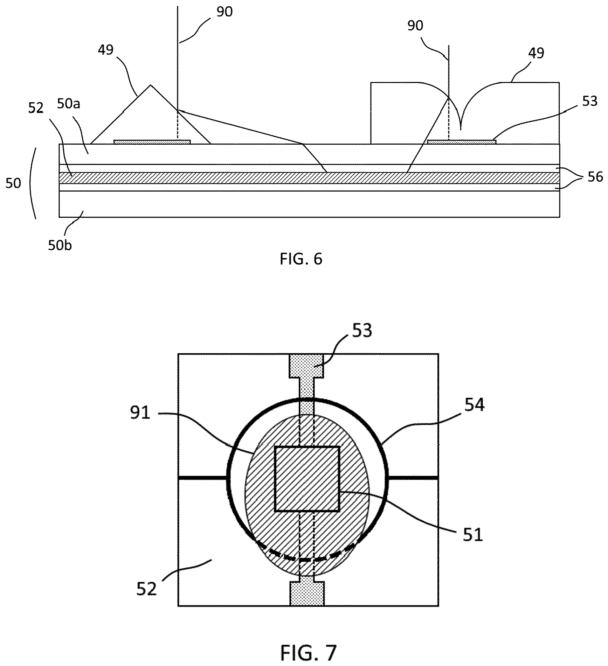

As shown in Figures 5 and 6, tertiary optical elements 49 can be arranged on top of the light energy conversion layer 50, more precisely on opaque and thus not converting structures of the layer 50, in order to modify the path of transmitted light 90 and ensure optimal transmission to the secondary light energy conversion elements 52. Examples of opaque structures include some connection lines 53 provided to electrically interconnect the primary light energy conversion elements 51 in form of PV cells, or pads on which the primary light energy conversion elements 51 or other electrical components are assembled. Tertiary optical elements 49 of reflective or refractive type can be used to "mask" these opaque structures and improve transmission of transmitted light 90 to the secondary light energy conversion elements 52.

Figure 7 displays a further embodiment of the present invention in which the geometries of interconnection lines 53, 54 of the primary, respectively secondary, light energy conversion elements 51, 52 are optimized in order to minimize shading and therefore maximize electrical current collection in the immediate vicinity of the primary light energy conversion elements 51. The interconnection lines 53 can be designed to be narrower in a region closed to the primary elements 51. Additionally, the connection lines 54, for instance a metallization grid, of the secondary elements 52 can have a square or circular shape around the primary elements 51, in order to minimize the path length from the illuminated area to these metallization lines. This is particularly advantageous when the focal spot formed by the transmitted light 91 is larger than the primary elements 51, and at least part of the transmitted light 91 is focused around the primary elements 51.

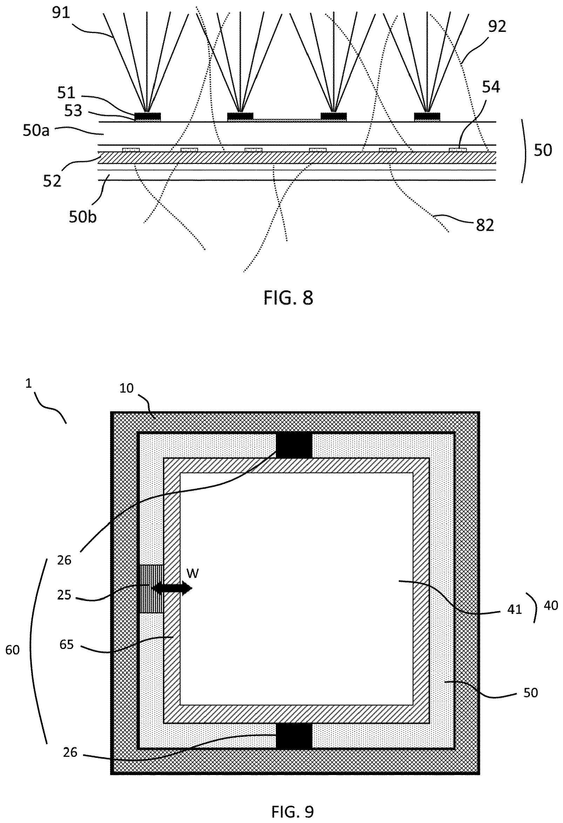

In the embodiment of the present invention illustrated in Figure 8, the secondary light energy conversion elements 52 are designed to collect light from both faces (top and bottom) of the optomechanical system 1. The secondary light energy conversion elements 52 are, in that embodiment, bifacial and mounted on a transparent substrate 55 which allows diffuse or reflected light 82 incident on the back of the optomechanical system 1 to be collected by the secondary elements 52.

In all the embodiments above, the primary, secondary and tertiary optical elements 47, 48, 49 can be made of glass, PMMA (acrylic), PC, silicone, or any other transparent or translucent materials. These optical elements can also be prisms with reflective coating such as metallization. The reflective coating can be applied for instance by a chemical process. The reflective coating can also be made of a sheet of material bonded or glued to the optical elements. Alternatively, the optical elements 47, 48, 49 can be coated with anti-reflective coating to improve optical transmission.

As mentioned above, the optical arrangement 40 or the light energy conversion layer 50 is advantageously mounted on a shifting mechanism in order to adapt the relative positon of the primary optical elements 47 towards the primary light energy conversion elements 51 as a function of the angle of the incident light 80. Details of different embodiments of the shifting mechanism are presented below. Important to note is that all presented embodiments of the shifting mechanism can be implemented with the different embodiments of the optical arrangement 40 or of the light energy conversion layer 50 presented above.

Figure 9 illustrates a schematic top view of an optomechanical system 1 according to another embodiment of the present invention. This optomechanical system 1 comprises the optical arrangement 40, the light energy conversion layer 50 and a shifting mechanism 60.

As can be seen in Figure 9, the shifting mechanism 60 comprises, in this embodiment, a translation element 65, one actuator 25 and two guiding elements 26. The optical arrangement 40, which comprises in this embodiment only a first optical layer 41, is mounted on the translation element 65, while the light energy conversion layer 50 is fixed to a frame 10. Thanks to guiding elements 26, the translation element 65 can move the optical arrangement 40 only in translation along the direction W. In other words, the shifting mechanism 60 is arranged to move the translation element 65 translationally with one degree of freedom.

The frame element 10 is an outer frame of the optomechanical system 1. In some embodiments, it is preferable that the frame element 10 surrounds entirely the optical arrangement 40, the light energy conversion layer 50 and the shifting mechanism 60. The frame element 10 can be made out of metal material such as aluminium, steel, stainless steel, or polymers such as ABS. The outer frame can be mounted for instance on areas such as commercial or residential rooftops solar rack mounts, or attached on single or dual-axis tracker structures (e.g. on utility-scale power plants).

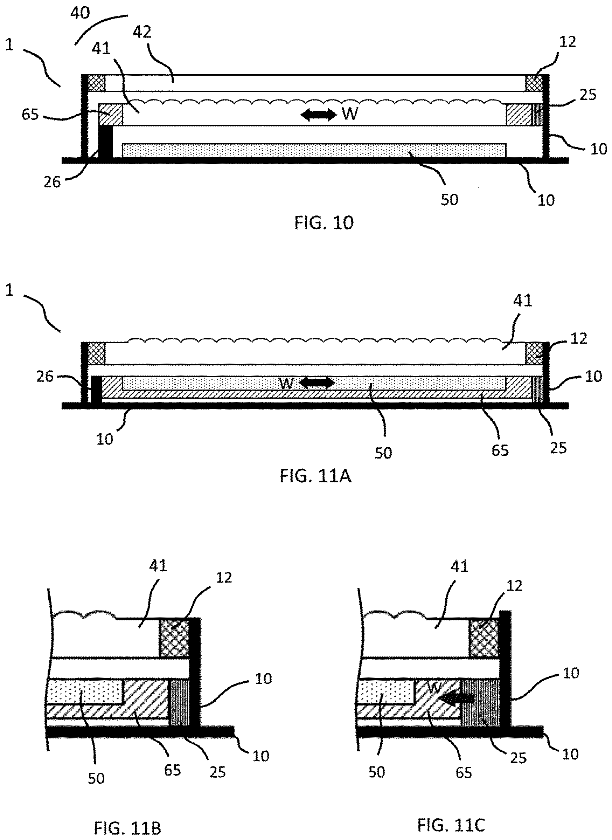

Figure 10 shows an optomechanical system 1 according to a further embodiment of the present invention. In this embodiment, the components 50 and 60 are encapsulated within a box formed by the frame element 10 and the optical arrangement 40. In this embodiment, the optomechanical system 1 comprises an optical arrangement 40 with two optical layers 41 and 42. The second optical layer 42 and the light energy conversion layer 50 are here attached to the frame element 10 and not movable. The attachment of the second optical layer 42 to the frame element 10 may be done through one or more joint 12. The first optical layer 41 of the optical arrangement 40 is mounted on the translation element 65. Thanks to the translation element 65, the first optical layer 41 can be moved translationally in the direction W through the actuation of the actuator 25. A guiding element 26 restricts the degrees of freedom of the translation element 65, so that it can only move in translation in the direction W.

Figures 11A to 11C illustrate an optomechanical system 1 according to yet another embodiment of the present invention. In this embodiment, the optical arrangement 40 comprises only the first optical layer 41, which is not movable due to its attachment to the frame element 10 through one or more joints 12. The light energy conversion layer 50 is mounted on a translation element 65. The translation element 65 of the shifting mechanism 60 is actuated by one actuator 25 and guided by a guiding element 26. Figures 11B and 11C are two detailed views from the schematic cross-sectional view of Figure 11A. As can be seen in these detailed views, thanks to the actuator 25 and the guiding element 26, the translation element 65 is moved translationally in a linear direction W.

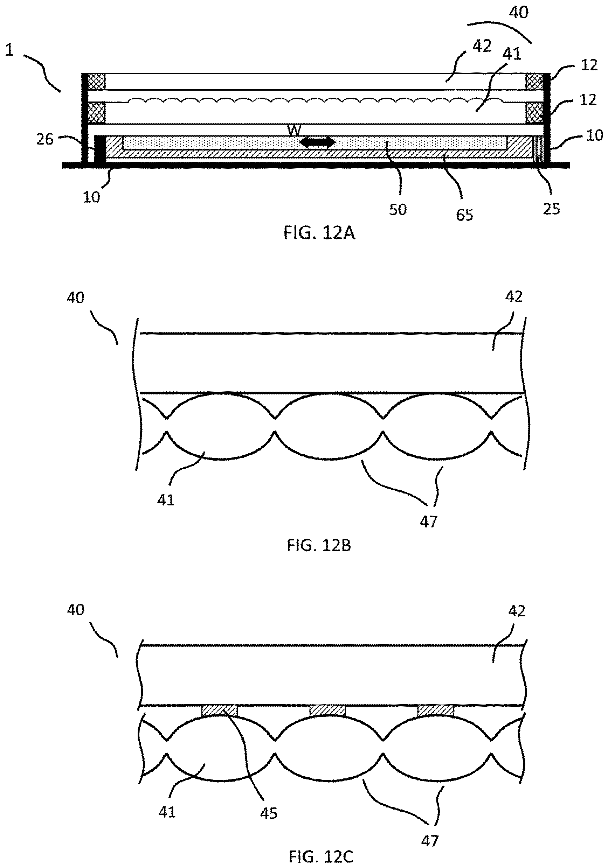

Figure 12A illustrates a further embodiment of the present invention. This embodiment is similar to the embodiment of the Figure 11A, except that the optical arrangement 40 is composed of the first and second optical layers 41 and 42. In this embodiment, both layers of the optical arrangement 40 are attached to the frame element 10 through one or more joints 12, and hence are not movable. The light energy conversion layer 50 is attached to the translation element 65. Thanks to the actuator 25 and the guiding element 26, the light energy conversion layer 50 mounted on the translation element 65 can be moved translationally in the direction W, as depicted in the Figure 11C.

In all the above-presented embodiments, the second optical layer 42 of the optical arrangement 40 has advantageously good optical properties, thus allowing for high light transmission, and good mechanical properties, to protect the optomechanical system from mechanical shocks or environmental pollution. For instance, the second optical layer 42 can be made of glass, PMMA (acrylic) or polycarbonate (PC). Of course, other suitable materials can also be used to manufacture this optical layer.

Flexible expansion joints 12 can be used to connect the first and second optical layers 41, 42 of the optical arrangement 40 to the frame element 10 in order to accommodate thermal expansion coefficients mismatches between the optical layers 41, 42 and the frame element 10.

The optomechanical system 1 of the above-presented embodiments of the present invention may comprise a venting system (not shown on the Figures), composed of one or more pressure equalization membranes, and incorporated into the frame element 10. The pressure equalization membranes can be made of rubber or Gore-Tex® material, for example. The advantage of a venting system is to regulate the pressure and humidity of the air enclosed within the frame element 10, in order to ensure that the optomechanical system 1 of the present invention can function in the most efficient manner.

Figures 12B and 12C illustrate two further embodiments of the present invention where the optical arrangement 40 is composed of the first and second optical layers 41 and 42 attached together. In Figure 12B, the two optical layers 41, 42 are directly bonded together, for instance by injection moulding, or using a plasma activation process. The two optical layers 41, 42 can also be bonded together by means of an intermediate adhesive layer 45, as for example silicone glue or UV cured acrylic glue, as depicted in Figure 12C.

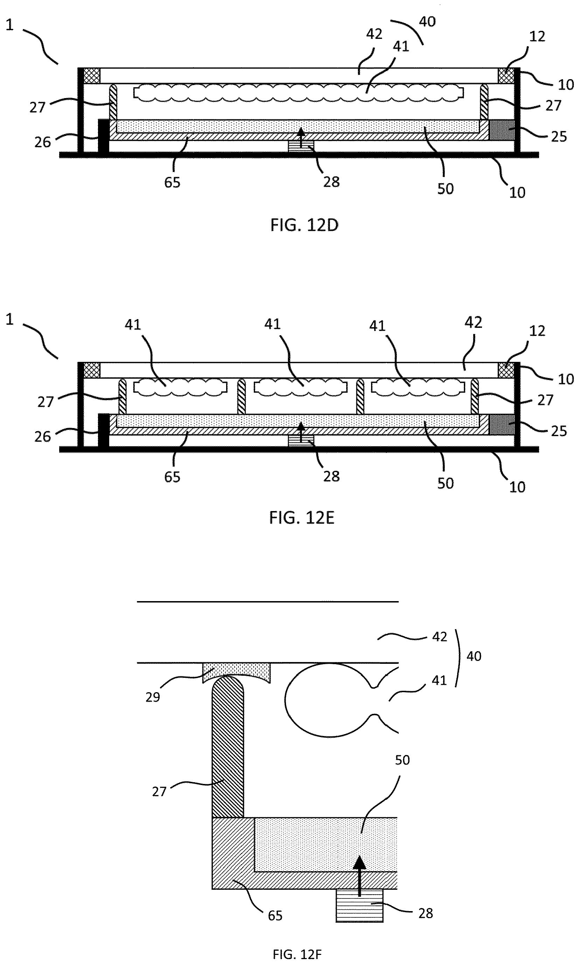

Thanks to the direct bonding of the first and second optical layers 41 and 42, it is possible, according to yet another embodiment of the present invention, to implement a plurality of sliders 27 that ensure, in combination with one or a plurality of pre-constraining elements 28, that the distance between the light energy conversion layer 50 and the optical arrangement 40 is constant over the whole optomechanical system, as shown in Fig. 12D. The pre-constraining elements 28 can for instance be springs or leaf springs. The number of sliders 27 is typically at least three in the direction of movement of the actuator 25 and increases with the size/surface of the panel. In order to accommodate a plurality of sliders, the first optical layer 41 of the optical arrangement 40 can be made of several blocks as illustrated in Fig. 12E.

The sliders 27 can slide directly on the surface of one of the layers of the optical system 1, if necessary with the addition of a coating to reduce friction, or according to a further embodiment of the present invention they can slide on flat or curved sliding pads 29, as shown in Fig. 12F. The curvature of the sliding pads 29 can be used to change the distance between the light energy conversion layer 50 and the optical arrangement 40 when the translation element 65 is moved laterally.

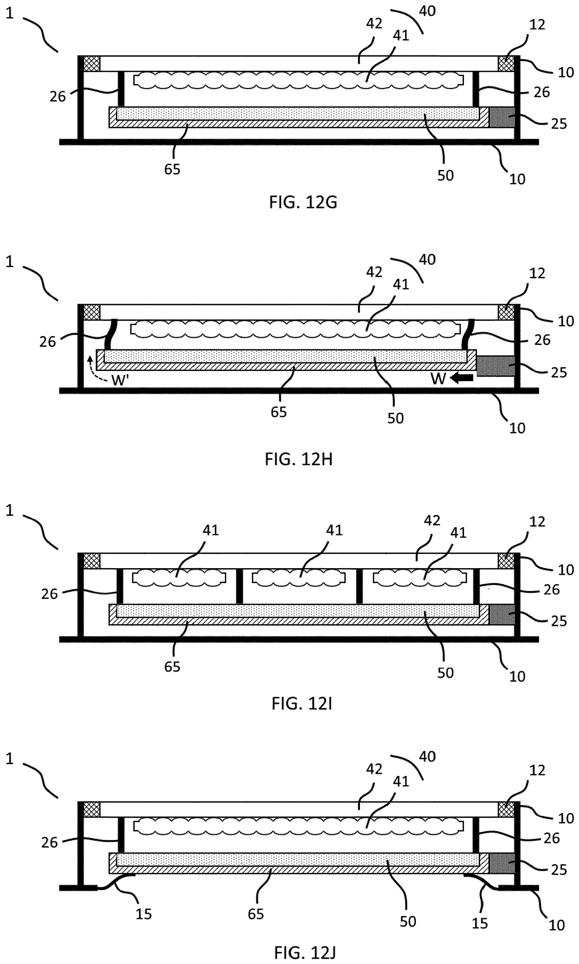

According to another embodiment of the present invention, the light energy conversion layer 50 is directly attached to the optical arrangement 40 by means of guiding elements 26, as shown in Figure 12G. In this case, the guiding elements 26 can be flexible guiding elements such as leaf springs, or any suitable type of flexible elements such as double ball joints, double magnetic ball joints or double universal joints (double cardan joints). As illustrated in Figure 12H, the guiding elements are designed in such a way that when the linear actuator 25 pushes or pulls the translation element 65 in the direction W, the light energy conversion layer 50, mounted on the translation element 65, moves along a curved trajectory W', for instance a portion of a paraboloid or a spherical trajectory. In other words, the guiding elements 26 transform the linear movement of the actuator 25 into a curved movement of the translation element 65.

Similarly to the embodiment with the sliders 27, a plurality of flexible guiding elements 26 can be implemented in the present embodiment as illustrated in Fig. 12I. In order to accommodate a plurality of flexible guiding elements, the first optical layer 41 of the optical arrangement 40 is made of several blocks.

According to a further embodiment, illustrated in Figure 12J, the frame 10 is at least partially open at the bottom and replaced by a flexible membrane 15. In this embodiment, the translation element 65 (and with it the light energy conversion layer 50) are directly exposed to ambient temperature and heat can therefore be dissipated by convection. The flexible membrane 15 seals the gaps between the translation element 65 and the frame 10, while allowing the translation element 65 to move both laterally and vertically.

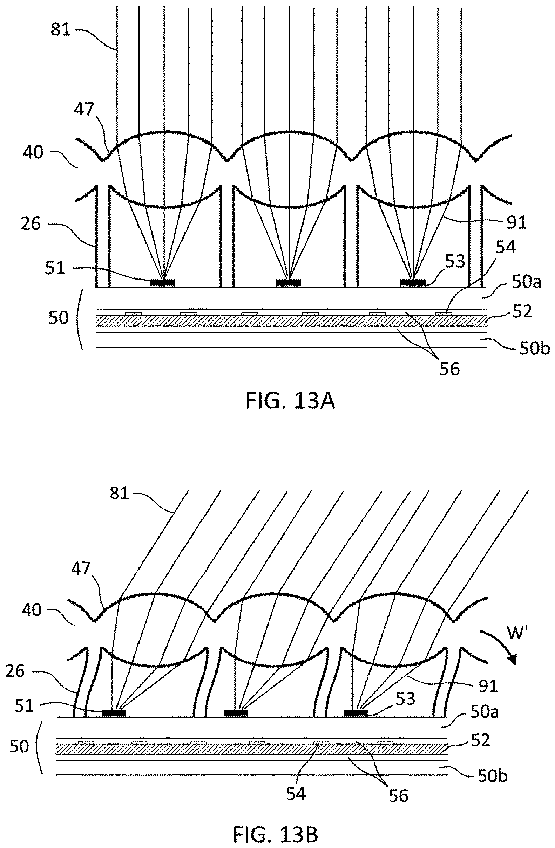

Figures 13A and 13B show another embodiment of the present invention in which the flexible guiding elements 26 can be foreseen as integral parts of the optical arrangement 40. As illustrated in Figure 13B, the flexible guiding elements 26 can advantageously be designed such that the optical arrangement 40 is moved along a curved trajectory W' when the shifting mechanism 60 is actuated. The flexible guiding elements 26 can be attached to the light energy conversion layer 50 by various means, including gluing, clamping or direct moulding onto the light energy conversion layer 50.

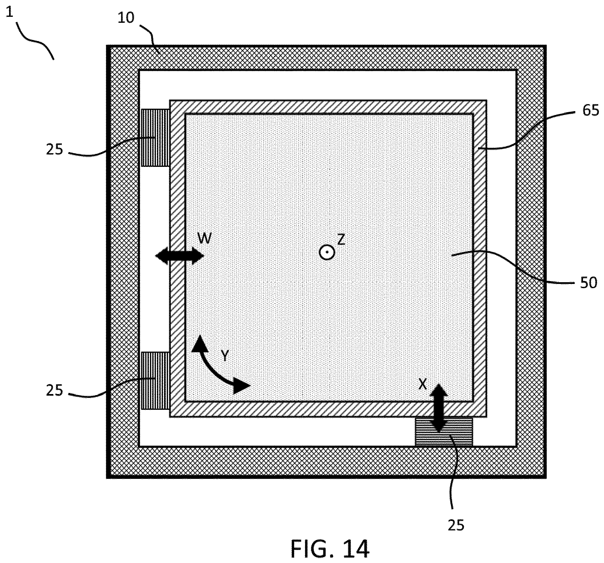

Figure 14 illustrates that, according to a further embodiment of the present invention, the shifting mechanism 60 comprises three actuators 25, two of which are disposed in parallel on the same axis W but at opposite ends of the translation element 65, and a third one in a direction normal to the first two. This configuration permits to control and cancel any parasitic rotation Y of the translation element 65 around the axis Z.

It goes without saying that the shifting mechanism 60 as shown in all embodiments of the present invention is capable of moving either one of the optical layers 41 or 42 of the optical arrangement 40 or the light energy conversion layer 50 translationally in one, two or three degrees of freedom relative to the frame element 10, thereby enabling the primary and secondary light energy elements 51 and 52 to collect transmitted light 90 optimally.

The different configurations of the present invention allow the translation element 65 of the optomechanical system 1 to perform only small strokes, ranging from for example from a few micrometers to a few centimeters. Such displacements are typically at least two orders of magnitude smaller than the outer size of the optomechanical system 1. The displacements could be for example of the same order of magnitude as the size of the primary optical elements 47. The displacements are limited to translational movements along one, two or three axes (with one, two or three degrees of freedom). Rotations are blocked or cancelled by means of a specific disposition of the guiding elements 26 combined with an arrangement of one or more actuator 25.

Although the present disclosure has been described with reference to particular means, materials and embodiments, one skilled in the art can easily ascertain from the foregoing description the essential characteristics of the present disclosure, while various changes and modifications may be made to adapt the various uses and characteristics as set forth in the following claims.

### Reference numbers

- 1: optomechanical system
- 10: frame element
- 12: joint
- 15: flexible membrane
- 25: actuator
- 26,26': guiding element
- 27: sliders
- 28: pre-constraining element
- 29: sliding elements
- 30: guiding module
- 40: optical arrangement
- 41: first optical layer
- 42: second optical layer
- 45: adhesive layer
- 47: primary optical element
- 48: secondary optical element
- 49: tertiary optical element
- 50: light energy conversion layer
- 50a: primary light energy conversion layer
- 50b: secondary light energy conversion layer
- 51: primary light energy conversion element
- 52: secondary light energy conversion element
- 53: primary connection lines
- 54: secondary connection lines
- 55: transparent substrate
- 56: encapsulant
- 57: insulator
- 58: reflective element
- 60: shifting mechanism
- 65: translation element
- 66: intermediate translation element
- 67: mobile attachment point
- 70: transparent cover
- 80: incident light
- 90: transmitted light

## Claims

1. An optomechanical system (1) for converting light energy, comprising
▪ an optical arrangement (40) comprising one or more optical layers (41, 42), wherein at least one of the optical layers (41,42) comprises a plurality of primary optical elements (47) to concentrate incident light (80) into transmitted light (90);
▪ a light energy conversion layer (50);
▪ a shifting mechanism (60) for moving at least one of the optical layers (41, 42) of the optical arrangement (40) relative to the light energy conversion layer (50) or vice versa; and
▪ a frame element (10) to which either the optical arrangement (40) or the light energy conversion layer (50) is attached,
wherein the light energy conversion layer (50) comprises a plurality of primary light energy conversion elements (51) and a plurality of secondary light energy conversion elements (52) capable of converting the energy of the transmitted light (90) into an output energy, wherein the primary light energy conversion elements (51) and the secondary light energy conversion elements (52) differ by type, and/or surface area, and/or light conversion efficiency, and/or light conversion spectrum, and wherein the output energy types of the primary light energy conversion elements (51) and of the secondary light energy conversion elements (52) can be different, and
wherein the shifting mechanism (60) is arranged to move at least one of the layers of the optical arrangement (40) or the light energy conversion layer (50) translationally relative to the frame element (10), through one or more translation element (65, 65') in such a way that the total output power of the primary light energy conversion elements (51) and of the secondary light energy conversion elements (52) can be adjusted.

2. The optomechanical system (1) according to claim 1, wherein the shifting mechanism (60) is arranged to move at least one of the layer of the optical arrangement (40) or the light energy conversion layer (50) in such a way that the total output energy power of the primary light energy conversion elements (51) and of the secondary light energy conversion elements (52) can be maximized.

3. The optomechanical system (1) according to any one of the claims 1 or 2, wherein the primary optical elements (47) are of reflective type such as mirrors or refractive type such as lenses including plano-convex, plano-concave, bi-convex, bi-concave, meniscus type and aspheric curvature having polynomial shape.

4. The optomechanical system (1) according to any one of the preceding claims, wherein it is configured such that direct sunlight is directed by means of the primary optical elements (47) to the primary light energy conversion elements (51) and such that diffuse sunlight is captured by the secondary light energy conversion elements (52).

5. The optomechanical system (1) according to any one of the preceding claims, wherein the primary light energy conversion elements (51) and/or the secondary light energy conversion elements (52) are photovoltaic cells.

6. The optomechanical system (1) according to claim 5, wherein both the primary light energy conversion elements (51) and the secondary light energy conversion elements (52) are single-junction photovoltaic cells of different types.

7. The optomechanical system (1) according to claim 5, wherein the primary light energy conversion elements (51) and secondary light energy conversion elements (52) are photovoltaic cells of the same type, and wherein the primary light energy conversion elements (51) and secondary light energy conversion elements (52) differ in surface area and/or shape.

8. The optomechanical system (1) according to claim 5, wherein the primary light energy conversion elements (51) are multi-junction and the secondary light energy conversion elements (52) are photovoltaic cells of another type.

9. The optomechanical system (1) according to any one of the preceding claims, wherein the secondary light energy conversion elements (52) are provided with holes into which the primary light energy conversion elements (51) can be placed and wherein the secondary light energy conversion elements (52) cover the surface of the light energy conversion layer (50) between the primary light energy conversion elements (51).

10. The optomechanical system (1) according to any one of the preceding claims, wherein the light energy conversion layer (50) comprise a primary light energy conversion layer (50a) and a secondary light energy conversion layer (50b) mounted on top of each other in direction of the optical arrangement (40), wherein the primary light energy conversion layer (50a) carries the primary light energy conversion elements (51) and the secondary light energy conversion layer (50b) carries the secondary light energy conversion elements (52).

11. The optomechanical system (1) according to claim 10, wherein the primary light energy conversion layer (50a) is provided with primary light energy conversion elements (51) designed to convert a specific range of wavelength of the transmitted light (90), advantageously short wavelengths from UV to visible light (for instance from 300 to 800 nanometers), while the rest of the transmitted light, such as infrared light (for instance above 800 nanometers) is transmitted through the primary light energy conversion layer (50a) to be converted by the secondary light energy conversion elements (52).

12. The optomechanical system (1) according to any one of the claims 10 or 11, wherein the primary light energy conversion layer (50a) is provided with holes arranged such that at least part of the transmitted light (90) can reach the secondary light energy conversion elements (52).

13. The optomechanical system (1) according to any one of the claims 10 or 12, wherein the primary light energy conversion layer (50a) is made of a transparent dielectric.

14. The optomechanical system (1) according to any one of the preceding claims, wherein the primary and secondary power outputs are combined using power electronics so that the optomechanical system is provided with a two-terminal power output.

15. The optomechanical system (1) according to any one of the preceding claims, wherein the secondary light energy conversion elements (52) are chosen for the conversion of the energy of a specific portion of the solar spectrum, advantageously the blue spectrum.

16. The optomechanical system (1) according to any one the preceding claims, wherein tertiary optical elements (49) are provided on top of the light energy conversion layer (50) in direction of the optical arrangement (40), wherein tertiary optical elements (49) are configured such that the amount of light impinging on a light converting area of the light energy conversion layer (50) is maximized.

17. The optomechanical system (1) to any one of the preceding claims, wherein the system (1) further comprises one or more sliders (27), arranged between the light energy conversion layer (50) and the optical arrangement (40), and one or more pre-constraining elements (28).

18. The optomechanical system (1) according to any of the preceding claims, wherein the shifting mechanism (60) further comprises one or more guiding elements (26, 26'), for instance one or more flexible guiding elements, such as a spring or leaf spring, in such a way that the one or more guiding elements (26, 26') are capable of limiting the degrees of freedom of the optical arrangement (40) and/or of the light energy conversion layer (50).

19. The optomechanical system (1) according to any one of the claims 27 or 28, wherein the light energy conversion layer (50) is directly attached to the optical arrangement (40) by means of guiding elements (26) such as double universal joints, for instance double cardan joints, double ball joints and/or by means of flexible guiding elements, such as a spring or leaf spring.

20. The optomechanical system (1) according to claim 19, wherein the guiding elements (26) are arranged to guide the movement of the optical arrangement (40) or the light energy conversion layer (50) on a paraboloid or on a spherical trajectory.

21. The optomechanical system (1) according to any one of the preceding claims, wherein the optical arrangement (40) comprises at least two optical layers (41, 42) that are bonded to each other either directly or by means of an adhesive layer (45).

22. The optomechanical system (1) according to claim 21, wherein one of the optical layers (41, 42) is made out of a rigid material, such as glass or acrylic (PMMA), and one of the optical layers (41, 42) is made of a flexible material, such as silicone rubber.

23. The optomechanical system (1) according to any one of the claims 21 or 22, wherein at least one of the optical layers (41, 42) is formed by molding, in particular by injection or compression molding.

24. The optomechanical system (1) according to any one of the preceding claims, wherein the primary optical elements (47) have a hexagonal or rectangular tiling contour and are arranged in an array.

25. The optomechanical system (1) according to any one of the preceding claims, wherein the translation element (65) of the shifting mechanism (60) comprises at least one actuator (25) and a control system such that at least one optical layer (41, 42) of the optical arrangement (40) or the light energy conversion layer (50) can be moved in one or more degrees of freedom in a translational movement.

26. The optomechanical system (1) according to claim 25, wherein two or more actuators (25) disposed in parallel to the same translational axis but at opposite ends of the translational element (65) and one or more actuators (25) disposed in a direction perpendicular to the first two.

27. The optomechanical system (1) according to any one of the claims 25 or 26, wherein the actuator (25) is an electro-mechanical actuator, an electro-static actuator, an piezo-electrical actuator, an stick-slip actuator or a pneumatic actuator.

28. The optomechanical system (1) according to any one of the preceding claims, further comprising a feedback control loop to monitor the position of the translation element (65) and/or the output power of the optomechanical system, wherein the feedback control loop is for example an optical sensor, a magnetic sensor or a photovoltaic sensor, a power meter or a combination of several of these sensors.

29. The optomechanical system (1) according to any one the preceding claims, wherein the frame (10) is at least partially open at the bottom and a flexible membrane (15) seals the gap between the translation element (65) and the frame (10) while allowing the translational element (65) to move both laterally and vertically.

30. The optomechanical system (1) according to any of the preceding claims, wherein the primary light energy conversion elements (51) are interconnected by primary connection lines (53).

31. The optomechanical system (1) according to claim 30, wherein the primary connection lines (53) are provided on the transparent dielectric.

32. The optomechanical system (1) according to any one of the claims 30 or 31, wherein the primary connection lines (53) are made out of a transparent conductive material, such as a transparent conductive oxide.

33. The optomechanical system (1) according to any one of the preceding claims, wherein the secondary light conversion elements (52) are interconnected by secondary connection lines (54) with a geometry designed to minimize energy losses due to shading and/or scattering.

34. The optomechanical system (1) according to any one of the preceding claims, wherein the output terminals of each of the primary light energy conversion elements (51) are interconnected by electrically conductive lines with a combination of series and parallel connections, to provide a primary two-terminal output and/or wherein the output terminals of each of the secondary light energy conversion elements (52) are interconnected by electrically conductive lines with a combination of series and parallel connections, to provide a secondary two-terminal output.

35. The optomechanical system (1) according to claim 34, wherein one of the terminals of the primary power output and one of the terminals of the secondary power output are connected, so that the optomechanical system is provided with a three-terminal output.

36. The optomechanical system (1) according to any one of the preceding claims, wherein the secondary light energy conversion elements (52) are bifacial.

37. The optomechanical system (1) according to any one the preceding claims, wherein secondary optical elements (48) of refractive type and/or of reflective type are mounted directly onto the primary light energy conversion elements (51) in order to further focus the transmitted light onto the primary light energy conversion elements (51).

38. The optomechanical system (1) according to claim 33, wherein the system (1) further comprises sliding pads (29) between a slider (27) and a surface they are sliding on.

39. The optomechanical system (1) according to claim 34, wherein the one or more guiding elements (26, 26') are capable of suppressing any rotational movement between the optical arrangement (40) and the light energy conversion layer (50).

40. A method for converting light energy with an optomechanical system (1) according to claim 1, comprising the steps of:
▪ concentrating incident light (80) into transmitted light (90);
▪ converting the energy of the transmitted light (90) into an output energy by means of the primary light energy conversion elements (51) and the secondary light energy conversion elements (52); and
▪ moving at least one of the optical layer (41,42) of the optical arrangement (40) relative to the light energy conversion layer (50) or vice versa,
wherein the shifting mechanism (60) moves the at least one of the optical layer (41, 42) of the optical arrangement (40) or the light energy conversion layer (50) translationally by one or more translation element (65) in such a way that the total output energy power of the primary light energy conversion elements (51) and of the secondary light energy conversion elements (52) is maximized.
